(19)

Europäisches
Patentamt
European
Patent Office
Office européen
des brevets

(11) **EP 2 187 444 A1**

(12) **EUROPEAN PATENT APPLICATION**

(43) Date of publication:
**19.05.2010 Bulletin 2010/20**

(51) Int Cl.:
*H01L 31/0224* (2006.01)      *C03C 3/064* (2006.01)
*C03C 3/066* (2006.01)       *C03C 8/04* (2006.01)
*C03C 8/18* (2006.01)        *H01B 1/22* (2006.01)

(21) Application number: **08019812.0**

(22) Date of filing: **13.11.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Gigastorage Corporation**
**Hukou Township**
**Hsin chu 303 (TW)**

(72) Inventors:
 • **Huang, Wen-Hui**
  **Hsinchu City 300 (TW)**
 • **Lin, Chin-Chang**
  **Hsinchu City 300 (TW)**

 • **Tai, Kuo-Hsun**
  **North District**
  **Hsinchu Vity 300 (TW)**
 • **Huang, Chien-Szu**
  **Jhudong Township**
  **Hsinchu County 310 (TW)**
 • **Wu, Jyun-Min**
  **Fongyuan City**
  **Taichung County 420 (TW)**
 • **Lin, Cheng-Hsun**
  **Banciao City**
  **Taipei County 220 (TW)**

(74) Representative: **Winkler, Andreas Fritz Ernst**
 **Forrester & Boehmert**
 **Pettenkoferstrasse 20-22**
 **80336 München (DE)**

(54) **Electroconductive paste composition, electrode and solar cell device comprising same**

(57)    A solar cell, comprising: a substrate, including p-n doping structure formed within said substrate; material attached to the back of said substrate, where said material includes glass mixture, aluminum material, organic medium and additive. Wherein said glass needs to be formed by combining two or more glasses: the main composition for post-mixed glass should include $Al_2O_3$, $Bi_2O_5$, $B_2O_3$, $SiO_2$ PbO or $Tl_2O_3$ and other metal and non-metal oxides. For the material composition, aluminum powder content is 60 - 80 mass %, with approximately 90 to 99.99% purity. Additives include $C_{10}$~$C_{24}$ stearic acid, with the content of less than 5 mass %. The $C_{10}$~$C_{24}$ stearic acid may include oleic acid. Organic medium content is roughly 20-35 mass %. Wherein said organic medium includes 60-90 mass % ether class organic solvent, 10-20 mass % cellulosic resin and 1-5 mass % of leveling agent, rheological agent or thixotropic agent.

Fig. 1

EP 2 187 444 A1

**Description**

Field of the Invention

The present invention relates to a solar cell, particularly relating to a method of forming a uniform aluminum-silicon alloy layer on the back of the silicon wafer to lower the structural stress caused by thin solar cells, thereby improving the warping phenomenon due to the stress on the silicon substrate.

Description of the Prior Art

Due to the high industrial development in recent years, fossil energy is rapidly depleting, aggravating environmental pollution over time. Therefore, due to the energy demands and environmental reasons, countries all over the world are dedicated to the development of alternative energy. Solar energy is the most abundant resource that maybe be utilized by mankind today, with the advantages of no transportation cost, clean and will not increase thermal load to the Earth. Due to the above advantages, at the present, solar energy is one of the clean renewable energies with the highest development potential.

Solar cell is a semiconductor component that utilizes photovoltaic effect to convert solar light energy into electric energy; basically any semiconductor diode may be used to convert light energy into electric energy. The electric energy produced by solar cell is based on two factors: photoconductive effect and internal electric field. Therefore, when selecting the material for solar cells, one needs to consider the photoconductive effect of the material and how to produce an internal electric field.

The performance of a solar cell is mainly determined by the conversion efficiency between light and electricity. The factors that would have an impact on the conversion efficiency include: the intensity and temperature of sunlight; resistance of the material and the quality and defect density of the substrate; concentration and depth of the p-n junction; surface reflectance against light; the line width, line height and contact resistance of the metal electrode. Hence, in order to produce solar cells with high conversion efficiency, tight control towards each of the impact factors mentioned above is necessary.

The conversion efficiency and cost of production are the main considerations for producing solar cells today. Among the solar cell products on the market today, solar cells made by silicon have the greatest market share. Categorizing by crystal structure, they can be divided into single-crystal silicon solar cell, polycrystalline silicon solar cell and amorphous silicon solar cell. From the perspective of conversion efficiency, single-crystal silicon solar cell is the most efficient with approximately 24% conversion efficiency, whereas polycrystalline silicon is about 19% and amorphous silicon is roughly 11%. By using other compound semiconductors as the light-electric conversion substrate, such as the III-V compound semiconductor GaAs, the conversion efficiency can be raised to 26% and above.

Finding ways to raise the energy conversion efficiency and lowering the thickness of silicon wafers is another major focus in the development of solar cell technology. With the problem of wafer thickness, existing technology utilizes a laser-fired contact (LFC) process to lower the thickness of the cell to below $37\,\mu$m, and raise the efficiency level to 20%. The steps involved are roughly as follows: use the evaporation process to create an aluminum layer and forming a passivation layer on the back of the solar cell, and utilize laser beams to penetrate the aluminum layer and form conducting contacts. The previous problem of losing electric energy may be resolved by the LFC technology and in addition, the traditionally expensive lithography and etching technology used to form holes within the passivation layer (located on the back of the silicon substrate) for holding aluminum electrode, is no longer required.

On the other hand, another existing technology adjusts the traditional screen printing method: by utilizing low warp aluminum paste (coating on the back of cell wafer) and halftones with high mesh count to lower the wafer broken rate; and undertakes the LFC process to improve the conversion efficiency.

However, the cost for LFC process is relatively high, and the performance of existing technology after improvement is still too low. Thus, raising the solar cell conversion efficiency and improving the warping phenomenon caused by thinning solar cells would be the current priority.

Summary of the Invention

The object of the present invention is to provide a thin solar cell with high conversion efficiency.

Another object of the present invention is to provide a mass production method by printing method to form aluminum paste required by solar cells.

Yet another object of the present invention is to improve the requirements of thin solar cells to reduce the warping of silicon wafer; lead-free process; and raise the conversion efficiency.

The present invention provides a solar cell, comprising: a substrate, including p-n doping structure formed within the substrate; material attached to the back of the substrate, where the material includes glass, aluminum-containing material, organic medium and additive. Wherein the glass is formed by combining two or more glasses: the main compositions for post-mixed glass include $Al_2O_3$, $Bi_2O_5$, $B_2O_3$, $SiO_2$, PbO, $Tl_2O_3$ or ZnO. Also, it is preferred to further include any of the following: $Fe_2O_3$ $P_2O_5$, MgO, $Ga_2O_3$, $Li_2O$, $Na_2O$, $ZrO_2$, AgO, $Sc_2O_5$, SrO, BaO, CaO, Pd, Pt and Rh. Wherein glass composition and aluminum powder content is roughly 60 ~ 80 mass %, with approximately 90 to 99.99% purity. Additives include $C_{10}$~$C_{24}$ stearic acid, with the content of less than 5 mass %, and the $C_{10}$~$C_{24}$ stearic acid may include oleic acid. Organic medium content is roughly 20~35 mass %. Wherein the organic medium includes 60~90 mass % ether class organic solvent, 10~20 mass % cellulosic resin and 1~5 mass % of leveling agent, rheological agent or thixotropic agent. The ether class organic solvent may include diethylene glycol monobutyl ether. The cellulosic resin may be ethyl cellulose. The leveling agent, rheological agent or thixotropic agent includes hydrogenated castor oil.

The present invention is offered to improve the conversion efficiency and reduce the warping issue of solar cells. The present invention employs the back surface field (BSF) effect structure, where it adds a specific ratio of aluminum, glass and organic medium to the back surface of solar cells, as verified by experiments, this technology is able to improve solar cells' conversion efficiency and enhance the rigidity to solve the problem of warping, thereby effectively reducing the wafer broken rate and improving the performance of solar cells. Furthermore, as the present invention only requires adding a specific ratio of aluminum paste material to achieve better performance than the two previously mentioned existing technology, not only will it reduce the wafer broken rate during the production process, but it will also reduce the production cost and improve the conversion efficiency.

Brief Description of the Drawings

The above objects, and other features and advantages of the present invention will become more apparent after reading the following detailed description when taken in conjunction with the drawings, in which:

FIG. 1 illustrates the focused ion beam (FIB) diagram of solar cells according to the embodiments of present invention;
FIG. 2 illustrates the focused ion beam (FIB) analysis result diagram of the aluminum layer located on the back surface of the control group within the embodiments of the present invention;
FIG. 3 illustrates the secondary ion mass spectrometry (SIMS) analysis result diagram of solar cells according to the embodiments of present invention;
FIG. 4 illustrates the diagrams for the experimental parameters (including temperature versus short circuit current, temperature versus extraction ratio, temperature versus open circuit voltage, and temperature versus conversion efficiency) of solar cells according to the embodiments of present invention;
FIG. 5 illustrates the diagrams for the experimental parameters (including temperature versus short circuit current, temperature versus extraction ratio, temperature versus open circuit voltage, and temperature versus conversion efficiency) of solar cells according to the embodiments of present invention;
FIG. 6 illustrates the diagrams for the experimental parameters (including temperature versus short circuit current, temperature versus extraction ratio, temperature versus open circuit voltage, and temperature versus conversion efficiency) of solar cells according to the embodiments of present invention.

Description of the Preferred Embodiment

Some sample embodiments of the invention will now be described in greater detail. Nevertheless, it should be recognized that the present invention can be practiced in a wide range of other embodiments besides those explicitly described, and the scope of the present invention is not expressly limited except as specified in the accompanying claims. Furthermore, portions of the diagrams are not shown to scale. Some dimensions of the related components are exaggerated and insignificant portions are not drawn to provide clearer description and comprehension of the present invention.

Please refer to the drawings, wherein the drawings displayed are only used to describe the preferred embodiments of the present invention, and is not used to limit the present invention. In the structure of small form factor, thin silicon wafer solar cell, in order to prevent the thin silicon wafer from deformation or warping, the present invention has discovered via research, that it is possible to form a special material or adhesive on the back surface of silicon wafer to change the structural stress, thus strengthen the overall solar cell structure and therefore improve the solar cell conversion efficiency and improve the structure's abilities against strain or stress. Moreover, the present invention utilizes the adhesive material formed on the back surface of solar cell wafer, where this film layer is able to effectively improve the conversion efficiency and prevent deformation. For example, the main compositions of the previously mentioned aluminum-silicon alloy layer material include aluminum powder, organic medium and glass frit.

In one embodiment, through changing the material or adhesive and utilizes the characteristic of glass frit to improve the degree of deformation, and raise the conversion efficiency of solar cells. This is also included in the concept of present invention.

The solar cell in the present invention, comprises: a substrate, such as silicon wafer for making individual solar cells. It includes a p-n doping structure formed therein, namely, n doped area and p doped area, are formed within the silicon wafer. Aluminum-silicon alloy layer is formed on the back surface of the silicon wafer, used to improve the structural stress of thin solar cells. Through the research and discovery of the present invention, it has been found that, by using a composition of aluminum powder, glass frit and organic medium as the adhesive material will reduce the structural stress to prevent the substrate from deformation. One characteristic of the present invention is to employ the multiple glass compositions to form the adhesive.

The adhesive (aluminum paste) mentioned above comprises: aluminum content of approximately 60~80%, with about 90 to 99.99% purity, average grain size is about 1-20$\mu$m, the shape may be spherical, spherical-like, granular, club-like, needle-like, pillar-like, scale-like, sponge-like, pointed-like, cone-like, porous-like, polygonal, sheet-like, bar-like, branch-like, fiber-like, and irregular, or any combination of the above shapes; organic medium, with the content of roughly 20~35 mass %, comprising 60~90 mass % of ether class solvent, 10~20 mass % of cellulosic resin and 1~5 mass % of leveling agent, rheological agent or thixotropic agent; additives, such as the $C_{10}$~$C_{24}$ stearic acid, with the content of less than 5 mass %, and the $C_{10}$~$C_{24}$ stearic acid may include oleic acid; glass frit, with the content of less than 5 mass %, and the compositions of the glass frit are described in the following tables. The following are shown for the purpose of embodiments rather than limiting the present invention. The ether class organic solvent mentioned above may include diethylene glycol monobutyl ether. The cellulosic resin may be ethyl cellulose. The leveling agent, rheological agent or thixotropic agent includes hydrogenated castor oil. From the preferred embodiments of the present invention, the adhesive is created by mixing at least two or more glass compositions listed in the following tables, depending on the chosen characteristics.

| Density (g/cm$^3$) | Softening Point (□) | Composition |
|---|---|---|
| 5.27 | 456 | $PbO\text{-}SiO_2\text{-}B_2O_3\text{-}Al_2O_3$ |
| 6.25 | 444 | $SiO_2\text{-}PbO\text{-}B_2O_3\text{-}Al_2O_3\text{-}ZrO_2$ |
| 6.84 | 463 | $Bi_2O_3\text{-}ZnO\text{-}SiO_2\text{-}B_2O_3\text{-}Al_2O_3$ |
| 5.27 | 583 | $SiO_2\text{-}SrO\text{-}Bi_2O_3\text{-}B_2O_3\text{-}Al_2O_3$ |
| 5.25 | 606 | $SiO_2\text{-}PbO\text{-}ZnO\text{-}B_2O_3\text{-}Al_2O_3\text{-}TiO_2$ |
| 5.88 | 457 | $SiO_2\text{-}PbO\text{-}ZnO\text{-}B_2O_3\text{-}Al_2O_3$ |
| 5.25 | 452 | $SiO_2\text{-}Bi_2O_3\text{-}B_2O_3\text{-}Al_2O_3\text{-}Tl\text{-}ZnO$ |
| 3.03 | 600 | $PbO\text{-}B_2O_3\text{-}SiO_2$ |

Other than the above mentioned glass compositions, other glass compositions may also be sued, such as:

$Bi_2O_3\text{-}SiO_2\text{-}ZnO\text{-}V_2O_5$, $Bi_2O_3\text{-}SiO_2\text{-}ZnO$, $Bi_2O_3\text{-}SiO_2\text{-}Al_2O_3$, $Bi_2O_3\text{-}SiO_2\text{-}V_2O_5$, $Bi_2O_3\text{-}SiO_2\text{-}B_2O_3\text{-}K_2O$, $Bi_2O_3\text{-}SiO_2\text{-}ZnO\text{-}B_2O_3\text{-}Li_2O\text{-}Na_2O\text{-}Nb_2O_5$, $PbO\text{-}SiO_2\text{-}ZnO\text{-}Al_2O_3$, $PbO\text{-}SiO_2\text{-}ZnO\text{-}Al_2O_3\text{-}Ta_2O_5$, $PbO\text{-}SiO_2\text{-}Al_2O\text{-}HfO_2\text{-}In_2O_3\text{-}Ga_2O_3$, $PbO\text{-}SiO_2\text{-}Al_2O_3\text{-}Ta_2O_5\text{-}ZrO_2$, $PbO\text{-}SiO_2\text{-}Al_2O_3\text{-}B_2O\text{-}Sb_2O_5$, $PbO\text{-}SiO_2\text{-}Al_2O_3\text{-}ZrO_2$, $PbO\text{-}SiO_2\text{-}Al_2O_3\text{-}P_2O_5\text{-}ZrO_2$, $PbO\text{-}SiO_2\text{-}Al_2O_3\text{-}B_2O_3\text{-}ZrO_2\text{-}Sb_2O_5$, $PbO\text{-}SiO_2\text{-}Al_2O_3\text{-}HfO_2$, $PbO\text{-}SiO_2\text{-}Ga_2O_3$, $SiO_2\text{-}ZrO_2\text{-}B_2O_3\text{-}ZnO\text{-}MgO\text{-}TiO_2\text{-}Na_2O\text{-}LiO_2\text{-}Bi_2O_3$.

From the experimental data illustrated in the present invention, it is evident that by following the adhesive compositions and production method described in the present invention will reduce the warping of solar cell substrate and raise the solar energy conversion efficiency. The present invention utilizes a method for altering the thermal expansion coefficient, where, through the mixing of different glass compositions and adding additives to change the expansion coefficient under room temperature, the expansion coefficient of the adhesive will be modified to be near the expansion coefficient of silicon substrate. In the preferred embodiment of the present invention, the main compositions of the post-mixed glass include $Al_2O_3$, $Bi_2O_5$, $B_2O_3$, $SiO_2$, PbO, $Tl_2O_3$ or ZnO. Also, it is preferred to further include any of the following:

$Fe_2O_3$, $P_2O_5$, MgO, $Ga_2O_3$, $Li_2O$, $Na_2O$, $ZrO_2$, AgO, $Sc_2O_5$, SrO, BaO, CaO, Pd, Pt, and Rh. Moreover, via following the adhesive compositions proposed by the present invention will strengthen the back surface field (BSF), and thereby increasing the conversion efficiency.

Examples of the glass composition:

| Glass Composition | First Glass Composition A mass % | Second Glass Composition B mass % |
|---|---|---|
| $Bi_2O_5$ | 70.3581 | 36.9380 |
| $SiO_2$ | 8.2120 | 8.8437 |
| SrO | 8.1478 | 0.0110 |
| $B_2O_3$ | 6.8102 | 6.8102 |
| CaO | 3.1635 | 0.0017 |
| $P_2O_5$ | 2.0863 | 2.4246 |
| $Al_2O_3$ | 1.2964 | 3.4351 |
| PbO | 0.1272 | 0.0020 |
| BaO | 0.0192 | 0.0021 |
| Pd | 0.0128 | 0.0000 |
| $Na_2O$ | 0.0116 | 0.0123 |
| ZnO | 0.0107 | 2.8787 |
| $Fe_2O_3$ | 0.0091 | 0.0091 |
| $Li_2O$ | 0.0035 | 0.9321 |
| MgO | 0.0032 | 0.0013 |
| $Sc_2O_5$ | 0.0030 | 0.0034 |
| $ZrO_2$ | 0.0019 | 0.0021 |
| $Ga_2O_3$ | 0.0009 | 0.0005 |
| AgO | 0.0009 | 0.0005 |
| Rh | 0.0007 | 0.0000 |
| Pt | 0.0005 | 0.0000 |
| $Tl_2O_3$ | 0.0000 | 35.7464 |
| Other | 0.0000 | 1.9500 |
| CTE (ppm/K) | 9.54 | 10.76 |
| Softening Point (□) | 583 | 451 |

The experimental groups are example 1, example 2, example 3, example 4, example 5, example 6, example 7, example 8, example 9 and example 10, and are compared to the control group. Through the above comparisons to observe the short circuit current, open circuit voltage, fill factor, relation between temperature and warping, and the relation between temperature and conversion efficiency, of the solar cell in the present invention. On the part of single crystal silicon wafer, the resistivity for p-type wafer is 1.2 Ωcm. The size of wafer chosen is dependent on the practical application. In a preferred embodiment, if the size of the wafer is 5 inches, then its side is 125mm; if the size is 6 inches, then its side is 150mm or 156mm. The thickness of the silicon wafer is 80~240μm. The steps to produce the solar cell of the present inventions are described below, however, these are not the characteristics of the present invention, in order to prevent the loss of focus, only general statements are provided and are not to be used to limit the present invention. It should be understood by those skilled in the art that, the adhesive described in the present invention is not limited to the structure or process described below, as it is only to be used as an embodiment of the present invention.

In a preferred embodiment, the selected wafer is a 4 inch single crystal wafer (10cm x 10cm), with the thickness of approximately 180~210μm; the general production steps for common solar cells include: (1) forming textured structure; (2) phosphorous diffusion; (3) wafer edge-grinding and removal of oxidation layer; (4) plasma-enhanced chemical vapor deposition (PECVD); (5) screen printing, screen printing includes front surface silver paste, back surface silver paste and back surface aluminum paste; (6) drying and sintering; (7) I-V electrical specifications measurement, as described below. However, in order to avoid the confusion of the present invention, steps that are less irrelevant to the present invention have been omitted, such as the high power microwave (HPM) cleaning, tempering and $H_2$ sintering etc.

(1) Forming textured structure: create a layer of anti-reflection coating with textured structure to lower the reflection of incident sunlight, without this anti-reflection layer, would result in approximately 30% reflection loss of the incident light, which is critical for solar cells. In order to lower the percentage that incident light is turned back through the first reflection, different sizes of pyramid textures are formed on the face of the illuminating surface of solar cell, the size of the pyramid is approximately a few microns.

(2) Phosphorous diffusion: generally, the depth of the n-type diffusion layer is only about $0.5\mu m$, therefore the p-n diode is practically formed on the surface of the pyramid texture. Generally it uses $POCl_3$, added with oxygen and nitrogen for diffusion at the high temperature diffusion furnace; the phosphorous atoms produced enter into the silicon lattice via high temperature diffusion, forming n-type doping. In order to form the p-n diode, the diffusion method is commonly used where n-type phosphorous diffusion is performed on the p-type silicon wafer.

(3) Wafer edge-grinding and removal of oxidation layer: the surface of silicon wafer would grow a native silica ($SiO_2$) layer. Hydrofluoric acids (HF) are used for the general removal of the silica layer on the surface. After this process, the p-type wafer may be coated with a layer of n-type dopant, which then removes the edges of the n-type layer through the process of edge etching, or using laser cutting to isolate the leakage current after sintering, forming the structure of p-n diode. If the edge isolation process is not carried out completely, then the shunt resistance (Rsh) of the solar cell will be lowered, and thus lowering the conversion efficiency of the solar cell.

(4) Plasma-enhanced chemical vapor deposition: crystalline silicon solar cell usually utilizes the plasma-enhanced chemical vapor deposition (PEVCD) method to coat a layer of silicon nitride (SiNx) onto the solar cell wafer, forming an anti-reflection coating (ARC) to effectively lower the reflection of incident light and provides the function of passivation, to be scratch resistant, moist resistant and to protect the solar cell.

(5) Screen printing: using screen printer to smear front surface silver paste, back surface silver paste, and back surface aluminum paste onto the front surface and back surface of the solar cell wafer respectively, forming metal contact via high temperature processing. The characteristic requirements of the silver electrode are: low series resistance; low metal coverage; and an anti-reflection layer with good adhesive property. The thinning of front surface silver paste metal finger would expand the area of the illuminating surface on solar cell, increase the intensity of incident light, provide effective collection of carriers, increase the density for currents produced through photovoltaic effect, and thus raise the light-electric conversion efficiency for solar cells.

At the present, most solar cells have the back surface field (BSF) structure, a distinctive feature of this structure is that it creates a layer of aluminum conducting paste on the back surface (non-illuminating surface), which diffuses aluminum into the p-type semiconductor under high temperature process, forming p+ layer. This method may increase the open circuit voltage ($V_{oc}$) value in the circuit, forming back surface field (BSF) effect and increase the conversion efficiency of solar cells.

As there is a difference between the thermal expansion coefficient of aluminum metal and the thermal expansion coefficient of silicon substrate, hence, when the thickness of the solar cell is lowered, the warping of solar cells would be increased, which then raises the wafer broken rate for solar cell module production process and also increases the difficulty for process integration. At the moment, the control of low warping is usually achieved through adjusting the compositions, which is mainly through the control of thermal expansion coefficients for glass added in the aluminum paste, thus, it is closely related to the selection of glass additives.

The back surface silver paste acts as the conducting line between the two solar cell panels, where its high conducting ability is able to serial connect the currents produced by solar cells. The p+ layer may be formed by the appropriate aluminum diffusion, and the back surface field (BSF) effect would increase the open circuit voltage for solar cells, therefore, the thickness and uniformity of back surface field (BSF) structure are related to the open circuit voltage and conversion efficiency. Generally, the back surface aluminum paste layer needs to be thick enough and needs to work in conjunction with the peak firing time and peak firing temperature to obtain the optimal open circuit voltage performance, and thus improve the conversion efficiency of solar cells.

(6) Drying and sintering: drying temperature is 200-300□, with the drying time of less than 20 seconds. The goal of drying is to allow the organic solvents of front surface silver paste, back surface silver and aluminum paste to evaporate. Sintering is usually done through the use of IR (infrared) belt furnace, with the sintering time of 2 to 3 minutes, and the peak firing temperature for sintering is 600-1000□. The goal of sintering is to allow the dispersion agents and organic mediums of front surface silver paste, back surface silver and aluminum paste to oxidize, evaporate and forming the back surface field (BSF) layer

(7) I-V Electrical specifications measurement: lastly, test the voltage-current curve (IV curve) of the solar cell, and other characteristics including the short circuit current, open circuit voltage and the conversion efficiency of solar cells.

The emphasis of the present invention is to form a special material or adhesive (such as the aluminum paste) on the back surface of the silicon wafer, to change the structural stress, strengthen the overall solar cell structure, improve solar cell conversion efficiency, and improve the structure's abilities against stress or strain.

Table 1 shows examples doped with different aluminum powder and glass frit compositions to form first glass composition A and second glass composition B, with no additives; the organic mediums include diethylene glycol monobutyl ether, ethyl cellulose and hydrogenated castor oil; the percentages are as follow: diethylene glycol monobutyl ether 85%, ethyl cellulose 13% and hydrogenated castor oil 2%. The warps are approximately 0.25-0.35mm and 0.20-0.25mm. The examples shown in Table 2 have the same solvent and aluminum powder to those in Table 1, however, two different glass frits have been heated and doped for recrystallization or non-recrystallization, and with no additives. The doping ratios of the two glasses are illustrated in Table 2. The doping ratio for first glass composition A and second glass composition B is between 1 and 9. It can be seen from the experimental data that, the conversion efficiency of control group is capable of reaching 14.13%. On the other hand, the best conversion efficiency of 14.07% can be achieved when the doping ratio of the experimental group is 1.5.

Table 3 shows an example with similar solvent to those in Table 2, with roughly 95% aluminum powder, and the ratio of first glass composition A and second glass composition B is about 1.5. It can be known from the experimental data that, at the sintering temperature of 905□, the conversion efficiency of the control group is 13.97%, while a much better result of 14.13% has been achieved by the experimental group. However, with the variation in temperature, the open circuit voltage of the cell in example 5 would be lower than that of the control group.

Table 4 illustrates examples with adjusted solid content, doped with two types of glasses (first glass composition A and second glass composition B), with added oleic acid of approximately below 1%. At the sintering temperature of 9250, the conversion efficiency of the present invention is 13.41%, with warping of 0.20~0.25mm; while the conversion efficiency of control group No. 12 is 13.14%, with warping of 0.60~0.75mm. When the sintering temperature is 905□, the conversion efficiency of the present invention is 13.48%, with warping of 0.25~0.35mm; while the conversion efficiency of control group No. 13 is 13.21%, with warping of 0.60~0.75mm.

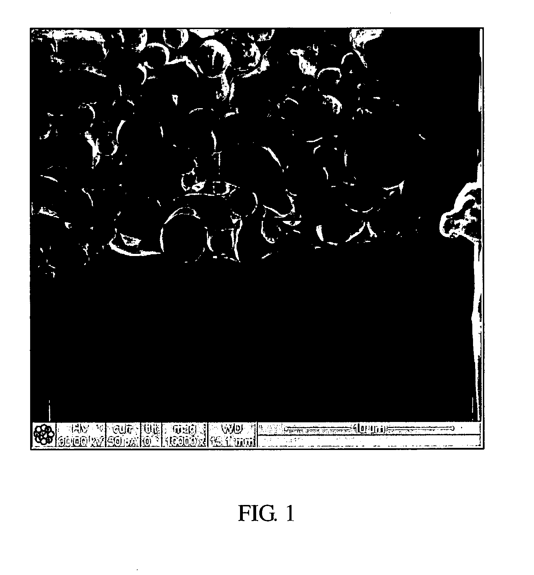

Referring to FIG. 1, which illustrates the focused ion beam (FIB) analysis results for the back surface aluminum layer in example 9. It can be seen from area A of the focused ion beam (FIB) analysis diagram of example 9 that, when it is sintered to form alloy, the aluminum would first lay flat on top of the silicon surface, then, diffused to the inner layer of the silicon substrate via diffusion mechanism, thus forming the aluminum-silicon alloy layer. However, this layer is determined by three parameters: composition of glass powder, size and shape of aluminum and extra aluminum paste additives. By determining the size and shape of the aluminum, the formation of aluminum-silicon alloy layer can be improved. When the contacting area for aluminum and silicon is increased, the aluminum that are in contact with silicon would have a higher proportion of diffusing into the silicon layer during the sintering process, thus increasing the thickness of aluminum-silicon alloy layer. It provides the reason for explaining how the conversion efficiency is raised as the aluminum shape is changed from circular to oval, as the oval aluminum has a greater area to be in contact with the silicon, and thus form a thicker aluminum-silicon alloy layer.

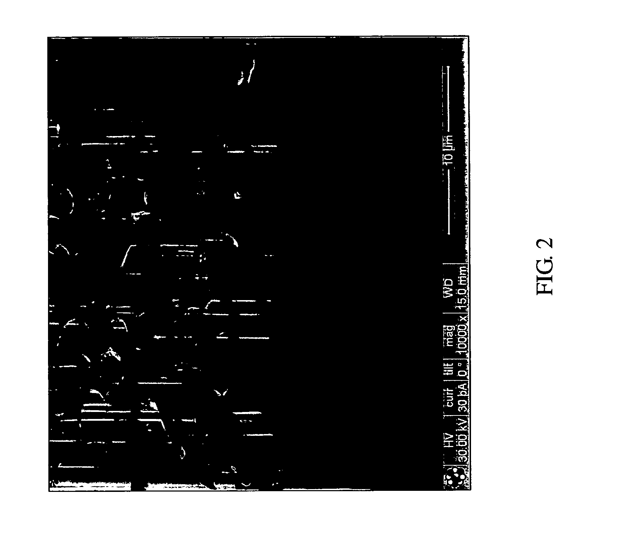

In addition, at the conducting part, FIG. 2 illustrates the focused ion beam (FIB) analysis results for the back surface aluminum layer of the control group. The structure of the control group has a better aluminum-silicon alloy layer, however, its efficiency is lower than example 9, and this may be due to its process of hole-transportation. Holes would move from the silicon layer to the aluminum-silicon alloy layer at first, then to the aluminum paste surface. During this process, the compactness of the aluminum plays an important factor. It can be easily observed in FIG. 2 that, at the unit area, the distribution of the aluminum is more scattered and with more gaps, the contacting areas between aluminums are less than that of example 9, which provides less path options for the transportation of holes, thus has a higher resistance and hence, lower the efficiency. In order to improve the compactness of aluminum, one might mix aluminums of different grain sizes, using smaller grain sized aluminums to fill the gaps of larger sized aluminums would increase its compactness, thus, achieve the goal of lowering the resistance and therefore, provide a highly efficient solar cell.

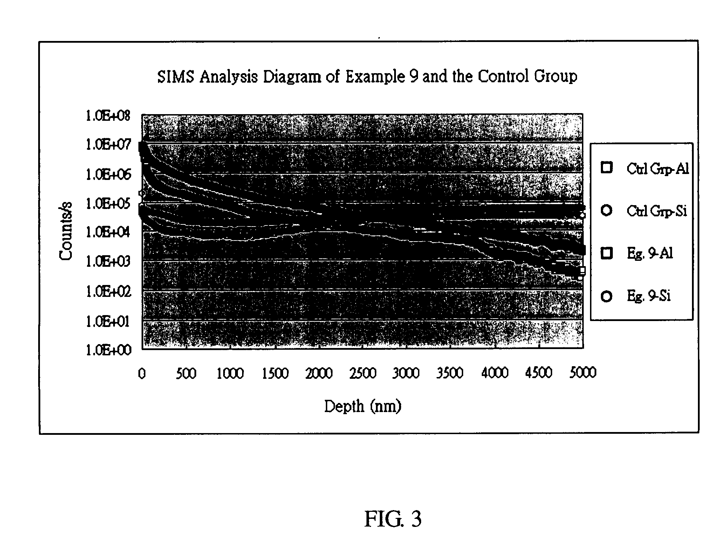

FIG. 3 is the secondary ion mass spectrometry (SIMS) analysis of example 9 and the control group. It is evident from this cross section analysis that, better conversion efficiency and lowest warping can be achieved by the present invention. The following points may be observed from the distribution curve:

1. Two different situations may be observed from the slopes of the aluminum curve. The slope is greater when the depth is about 100nm, then it flattens, this may be due to the residual aluminum on the surface layer between 0 and 100nm. The index attenuates after depth is greater than 100nm, this shows that portions of aluminum has diffused into the silicon wafer, and the curve is consistent with the diffusion formula:

$$N = \alpha No \, \exp(-\beta s)$$

($\alpha$ is the material factor, $\beta$ is the diffusion coefficient, s is the diffusion depth, No is the atom number per unit area, and N is the diffusion number per unit area)

2. As the aluminum diffuses after the depth of 3750nm, there are minor oscillations with the signal, which indicates the un-uniformity of the aluminum diffusion concentration distribution within this depth.

3. Signal smoothes out after the depth of 3500nm.

4. It is estimated that the aluminum signal of example 9 would reach 0 after the depth of 11.5$\mu$m, whereas the aluminum signal of the control group would reach 0 after the depth of 10$\mu$m, which indicates that the aluminum-silicon alloy layer of example 9 is thicker than the aluminum-silicon alloy layer of the control group. Therefore, the back surface field (BSF) layer of example 9 is thicker, and the open circuit voltage would be higher.

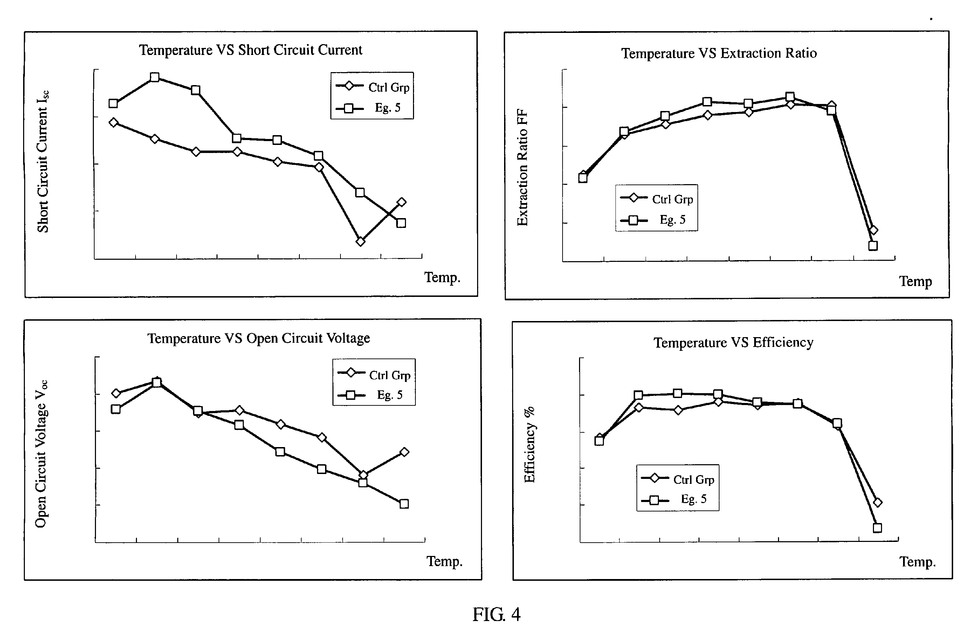

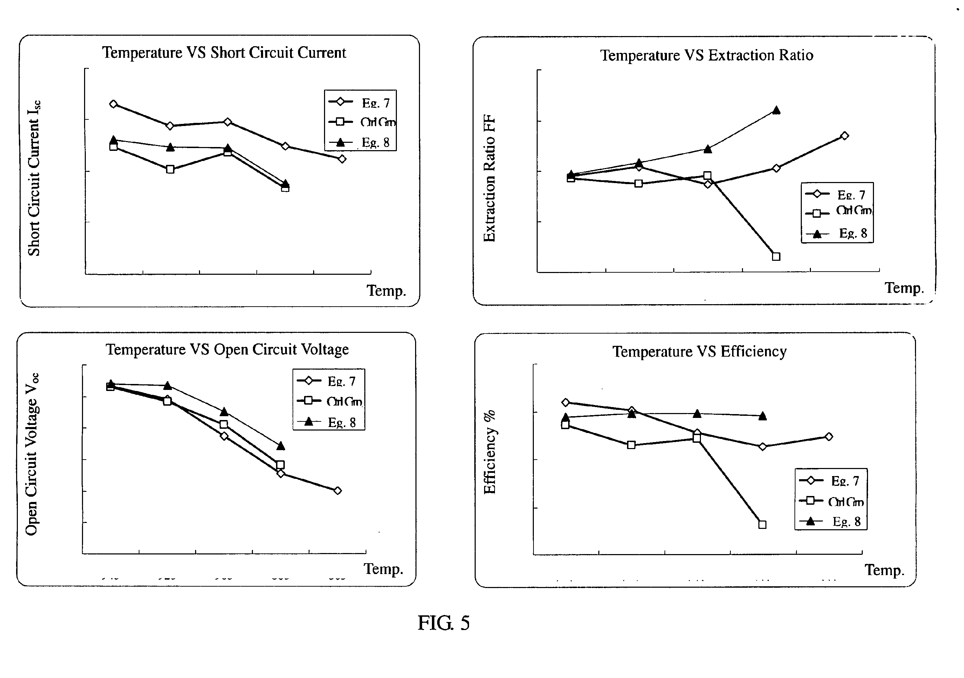

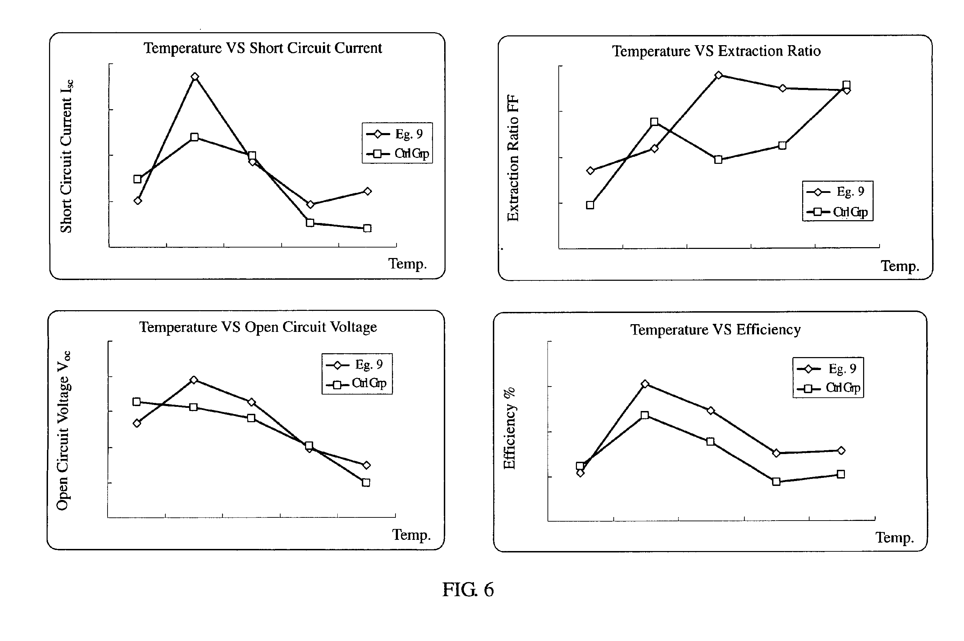

FIG. 4 to FIG. 6 illustrate the temperature versus short circuit current, temperature versus extraction ratio, temperature versus open circuit voltage, temperature versus conversion efficiency and other sample experimental parameters. From the temperature distribution, the cell electrical specifications of example 7 and example 8 are higher than those of the control group, and the warping is also smaller. Through adjusting the material solid content and mixing the two glasses with this particular ratio, it would be possible to achieve the high conversion efficiency and low warping characteristics.

From the above, it is evident that the present invention would be able to raise the solar energy conversion efficiency and lower the warping. Warping is calculated by the following formula:

$$\delta = \frac{3\left(\alpha_b - \alpha_a\right)\left(T_f - T\right)\left(t_b + t_a\right)d^2}{4t_b^{\,2}\left(4 + 6t_a/t_b + 4\left(t_a/t_b\right)^2 + \left(E_a/E_b\right)\left(t_a/t_b\right)^3 + \left(E_b/E_a\right)\left(t_b/t_a\right)\right)}$$

where $\delta$ is the warping, $t_a$ is the thickness of the silicon material, $t_b$ is the thickness of aluminum paste, $T_f$ is the inversion temperature for aluminum, T is the room temperature, $\alpha_a$ is the silicon expansion coefficient, $\alpha_b$ is the aluminum expansion coefficient, $E_a$ is the modulus of elasticity for silicon, $E_b$ is the modulus of elasticity for aluminum, and d is the length of the cell.

In addition, the inversion temperature for aluminum is 577$\square$, temperature of the environment is 25$\square$, expansion coefficient for silicon is 3.5 ppm/K, expansion coefficient for aluminum is 23 ppm/K, elastic modulus for silicon is roughly 110GPa, and the elastic modulus for aluminum is roughly 70GPa. In principle, the factors that would influence warping are only those related to the thickness of aluminum paste and the thickness of silicon substrate. Moreover, aluminum paste is only doped with less than 5% of glass, and the distribution of glass within the whole area (10cm x 10cm) is roughly 0.4$\mu$m. Formulae for calculating the four important parameters: short circuit current, open circuit voltage, fill factor and conversion efficiency are listed below.

Short Circuit Current Isc:

$$I = I_o\left(e^{qV/kT} - 1\right) - I_L$$

Open Circuit Voltage Voc:

$$V_{oc} = \frac{kT}{q}\ln\left(\frac{I_L}{I_o} + 1\right)$$

Fill Factor FF:

$$FF = \frac{V_{mp} I_{mp}}{V_{oc} I_{sc}}$$

Conversion Efficiency $\eta$:

$$\eta = \frac{V_{mp} I_{mp}}{P_{in}} = \frac{V_{oc} I_{sc} FF}{P_{in}}$$

Although preferred embodiments of the present invention have been described, it will be understood by those skilled in the art that the present invention should not be limited to the described preferred embodiments. Rather, various changes and modifications can be made within the spirit and scope of the present invention, as defined by the following Claims.

Table 1

| Number | Organic Medium (30 mass%) | | | Solid Content (70 mass%) (Aluminum Powder and Glass Frit) | | | Additives (mass %) | Sintering Temperature (°C) | Efficiency (%) | Warping (mm) |
|---|---|---|---|---|---|---|---|---|---|---|
| | Diethylene Glycol Monobutyl Ether (mass %) | Cellulosic Resin (mass %) | Hydrogenated Castor Oil (mass%) | Aluminum (mass%) | Glass Type | Glass Frit (mass %) | | | | |
| Example 1 | 85 | 13 | 2 | > 95 | A | < 5 | - | 965 | 12.14 | 0.25~0.35 |
| Example 2 | 85 | 13 | 2 | > 95 | B | < 5 | - | 965 | 13.64 | 0.20~0.25 |

Table 2

| Number | Organic Medium (30 mass%) | | | Solid Content (70 mass%) (Aluminum Powder and Glass Frit) | | | Additives (mass %) | Sintering Temperature (°C) | Efficiency (%) | Warping (mm) |
|---|---|---|---|---|---|---|---|---|---|---|
| | Diethylene Glycol Monobutyl Ether (mass %) | Cellulosic Resin (mass %) | Hydrogenated Castor Oil (mass %) | Aluminum (mass%) | Glass Type | Doping Ratio A: B | | | | |
| Example 3 | 85 | 13 | 2 | > 95 | A / B | 9 | - | 965 | 13.91 | - |
| Example 4 | 85 | 13 | 2 | > 95 | A / B | 3 | - | 965 | 14.04 | - |
| Example 5 | 85 | 13 | 2 | > 95 | A / B | 1.5 | - | 965 | 14.07 | - |
| Example 6 | 85 | 13 | 2 | > 95 | A / B | 1 | - | 965 | 14.02 | - |

Table 3

| Number | Organic Medium (30 mass%) | | | Solid Content (70 mass%) (Aluminum Powder and Glass Frit) | | | Additives (mass %) | Sintering Temperature (°C) | Efficiency (%) | Warping (mm) |
|---|---|---|---|---|---|---|---|---|---|---|
| | Diethylene Glycol Monobutyl Ether (mass %) | Cellulosic Resin (mass %) | Hydrogenated Castor Oil (mass %) | Aluminum (mass%) | Glass Type | Doping Ratio A:B | | | | |
| Example 5 | 85 | 13 | 2 | > 95 | A | 1.5 | - | 905 | 14.13 | - |
| | | | | | B | | | | | |

Table 4

| Number | Organic Medium (26 mass%) | | | Solid Content (74 mass%) (Aluminum Powder and Glass Frit) | | | Additives (mass %) | Sintering Temperature (°C) | Efficiency (%) | Warping (mm) |
|---|---|---|---|---|---|---|---|---|---|---|
| | Diethylene Glycol Monobutyl Ether (mass %) | Cellulosic Resin (mass %) | Hydrogenated Castor Oil (mass %) | Aluminum (mass%) | Glass Type | Doping Ratio A:B | | | | |
| Example 7 | 85 | 13 | 2 | > 95 | A | 1.5 | Oleic Acid > 1 | 925 | 13.41 | 0.20~0.25 |
| | | | | | B | | | | | |
| Example 8 | 85 | 13 | 2 | > 95 | A | 1.5 | Oleic Acid > 1 | 905 | 13.48 | 0.25~0.35 |
| | | | | | B | | | | | |
| Example 9 | 85 | 13 | 2 | > 95 | A | 1.5 | Oleic Acid > 1 | 945 | 13.73 | 0.40~0.45 |
| | | | | | B | | | | | |
| Example 10 | 85 | 13 | 2 | > 95 | A | 1.5 | Oleic Acid > 1 | 945 | 14.42 | 0.60~0.75 |
| | | | | | B | | | | | |

**Claims**

1.  A solar cell, comprising:

    a substrate having a p-n doped structure formed therein; and
    a material attached on the back surface of said substrate, wherein said material includes a mixture of glass, organic medium, aluminum-containing material and additives.

2.  The solar cell of Claim 1, wherein the main compositions of said mixture of glass include $Al_2O_3$, $Bi_2O_5$, $B_2O_3$, $SiO_2$, PbO, $Tl_2O_3$ or ZnO, preferably, further include $Fe_2O_3$ $P_2O_5$, MgO, $Ga_2O_3$, $Li_2O$, $Na_2O$, $ZrO_2$, AgO, $Sc_2O_5$, SrO, BaO, CaO, Pd, Pt, or Rh.

3.  The solar cell of Claim 1, wherein said mixture of glass includes at least two main compositions, wherein said at least two main compositions include a first glass composition and a second glass composition.

4.  The solar cell of Claim 3, wherein said first glass composition is selected from the group consisting of: PbO-$SiO_2$-$B_2O_3$-$Al_2O_3$; $SiO_2$-PbO-$B_2O_3$-$Al_2O_3$-$ZrO_2$; $Bi_2O_3$-ZnO-$SiO_2$-$B_2O_3$-$Al_2O_3$; $SiO_2$-SrO-$Bi_2O_3$-$B_2O_3$-$Al_2O_3$; $SiO_2$-PbO-ZnO-$B_2O_3$-$Al_2O_3$-$TiO_2$; $SiO_2$-PbO-ZnO-$B_2O_3$-$Al_2O_3$; $SiO_2$-$Bi_2O_3$-$B_2O_3$-$Al_2O_3$-Tl-ZnO; PbO-$B_2O_3$-$SiO_2$; $Bi_2O_3$-$SiO_2$-ZnO-$V_2O_5$; $Bi_2O_3$-$SiO_2$-ZnO; $Bi_2O_3$-$SiO_2$-$Al_2O_3$; $Bi_2O_3$-$SiO_2$-$V_2O_5$; $Bi_2O_3$-$SiO_2$-$B_2O_3$-$K_2O$; $Bi_2O_3$-SiO-ZnO-$B_2O_3$-$Li_2O$-$Na_2O$-$Nb_2O_5$; PbO-$SiO_2$-ZnO-$Al_2O_3$; PbO-$SiO_2$-ZnO-$Al_2O_3$-$Ta_2O_5$; PbO-$SiO_2$-$Al_2O_3$-$HfO_2$-$In_2O_3$-$Ga_2O_3$; PbO-$SiO_2$-$Al_2O_3$-$Ta_2O_5$-$ZrO_2$; PbO-$SiO_2$-$Al_2O_3$-$B_2O_3$-$Sb_2O_5$; PbO-$SiO_2$-$Al_2O_3$-$ZrO_2$; PbO-$SiO_2$-$Al_2O_3$-$P_2O_5$-$ZrO_2$; PbO-$SiO_2$-$Al_2O$-$B_2O_3$-$ZrO_2$-$Sb_2O_5$; PbO-$SiO_2$-$Al_2O_3$-$HfO_2$; PbO-$SiO_2$-$Ga_2O_3$; $SiO_2$-$ZrO_2$-$B_2O_3$-ZnO-MgO-$TiO_2$-$Na_2O$-$LiO_2$-$BhO_3$; and the combination thereof.

5.  The solar cell of Claim 3, wherein said second glass composition is selected from the group consisting of: PbO-$SiO_2$-$B_2O_3$-$Al_2O_3$; $SiO_2$-PbO-$B_2O_3$-$Al_2O_3$-$ZrO_2$; $Bi_2O_3$-ZnO-$SiO_2$-$B_2O_3$-$Al_2O_3$; $SiO_2$-SrO-$Bi_2O_3$-$B_2O_3$-$Al_2O_3$; $SiO_2$-PbO-ZnO-$B_2O_3$-$Al_2O_3$-$TiO_2$; $SiO_2$-PbO-ZnO-$B_2O_3$-$Al_2O_3$; $SiO_2$-$Bi_2O_3$-$B_2O_3$-$Al_2O_3$-Tl-ZnO; PbO-$B_2O_3$-$SiO_2$; $Bi_2O_3$-$SiO_2$-ZnO-$V_2O_5$; $Bi_2O_3$-$SiO_2$-ZnO; $Bi_2O_3$-$SiO_2$-$Al_2O_3$; $Bi_2O_3$-$SiO_2$-$V_2O_5$; $Bi2O_3$-$SiO_2$-$B_2O_3$-$K_2O$; $Bi_2O_3$-$SiO_2$-ZnO-$B_2O_3$- $Li_2O$-$Na_2O$-$Nb_2O_5$; PbO-$SiO_2$-ZnO-$Al_2O_3$; PbO-$SiO_2$-ZnO-$Al_2O_3$-$Ta_2O_5$; PbO-$SiO_2$-$Al_2O_3$-$HfO_2$-$In_2O_3$-$Ga_2O_3$; PbO-$SiO_2$-$Al_2O_3$-$Ta_2O_5$-$ZrO_2$; PbO-$SiO_2$-$Al_2O_3$-$B_2O_3$-$Sb_2O_5$; PbO-$SiO_2$-$Al_2O_3$-$ZrO_2$; PbO-$SiO_2$-$Al_2O_3$-$P_2O_5$-$ZrO_2$; PbO-$SiO_2$-$Al_2O_3$-$B_2O_3$-$ZrO_2$-$Sb_2O_5$; PbO-$SiO_2$-$Al_2O_3$-$HfO_2$; PbO-$SiO_2$-$Ga_2O_3$; $SiO_2$-$ZrO_2$-$B_2O_3$-ZnO-MgO-$TiO_2$-$Na_2O$-$LiO_2$-$Bi_2O_3$; and the combination thereof.

6.  The solar cell of Claim 1, wherein said aluminum-containing material includes aluminum powder content of 60~80 mass %, with the purity of 90 to 99.99%.

7.  The solar cell of Claim 1, wherein the average grain size of aluminum in said aluminum-containing material is approximately 1~20$\mu$m, and the shape is selected from the group consisting of spherical, spherical-like, granular, club-like, needle-like, pillar-like, scale-like, sponge-like, pointed-like, cone-like, porous-like, polygonal, sheet-like, bar-like, branch-like, fiber-like, irregular , and the combination thereof.

8.  The solar cell of Claim 1, wherein said additives include $C_{10}$~$C_{24}$ stearic acid or oleic acid, wherein the content of said $C_{10}$~$C_{24}$ stearic acid or oleic acid is less than 5 mass %.

9.  The solar cell of Claim 1, wherein the content of said organic medium is roughly 20~35 mass %, wherein said organic medium includes: 60~90 mass % of ether class solvent, which further includes diethylene glycol monobutyl ether; 10~20 mass % of cellulosic resin, which further includes ethyl cellulose; and 1~5 mass % of leveling agent, rheological agent or thixotropic agent, which further include hydrogenated castor oil.

10. An adhesive material, comprising:

    a mixture of glass, organic medium, material with aluminum and
    additives, wherein the main compositions of said mixture of glass include $Al_2O_3$, $Bi_2O_5$, $B_2O_3$, $SiO_2$, PbO, $Tl_2O_3$ or ZnO, preferably, further include $Fe_2O_3$ $P_2O_5$, MgO, $Ga_2O_3$, $Li_2O$, $Na_2O$, $ZrO_2$, AgO, $Sc_2O_5$, SrO, BaO, CaO, Pd, Pt, or Rh.

FIG. 1

FIG. 2

FIG. 3

EP 2 187 444 A1

FIG. 4

FIG. 5

FIG. 6

Europäisches
Patentamt

European
Patent Office

Office européen
des brevets

## EUROPEAN SEARCH REPORT

**Application Number**

EP 08 01 9812

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 775 776 A (DU PONT [US]) 18 April 2007 (2007-04-18) * abstract; figures 1A-1F * * paragraphs [0016] - [0018], [0022] - [0034], [0040] * | 1-7,9-10 | INV. H01L31/0224 C03C3/064 C03C3/066 C03C8/04 C03C8/18 H01B1/22 |
| X | EP 1 713 094 A (DU PONT [US]) 18 October 2006 (2006-10-18) * abstract; figure 1 * * paragraphs [0018] - [0035]; table 1 * | 1-2,7, 9-10 | |
| X | JP 2000 090734 A (MURATA MANUFACTURING CO) 31 March 2000 (2000-03-31) * abstract; figures 1,2 * * paragraphs [0021] - [0042]; figures 1,2 * | 1-2,7-10 | |
| A | US 5 320 684 A (AMICK JAMES [US] ET AL) 14 June 1994 (1994-06-14) * abstract; figure 5 * * column 9, line 23 - column 10, line 43 * | 1-5,9 | |
| A | US 2004/003836 A1 (WATSUJI TAKASHI [JP] ET AL) 8 January 2004 (2004-01-08) * abstract; figures 1,2 * * table 1 * * paragraphs [0025] - [0044] * | 1-2,7, 9-10 | TECHNICAL FIELDS SEARCHED (IPC) H01L C03C H05B |

The present search report has been drawn up for all claims

| Place of search | Date of completion of the search | Examiner |
|---|---|---|
| Berlin | 17 March 2010 | Favre, Pierre |

EPO FORM 1503 03.82 (P04C01)

## ANNEX TO THE EUROPEAN SEARCH REPORT
## ON EUROPEAN PATENT APPLICATION NO.

EP 08 01 9812

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2010

| Patent document cited in search report | | Publication date | Patent family member(s) | | Publication date |
|---|---|---|---|---|---|
| EP 1775776 | A | 18-04-2007 | KR 20070040308 A | | 16-04-2007 |
| | | | US 2007079868 A1 | | 12-04-2007 |
| EP 1713094 | A | 18-10-2006 | AU 2006201557 A1 | | 02-11-2006 |
| | | | CN 101055776 A | | 17-10-2007 |
| | | | JP 2006313744 A | | 16-11-2006 |
| | | | KR 20060108552 A | | 18-10-2006 |
| | | | US 2006231803 A1 | | 19-10-2006 |
| | | | US 2009140217 A1 | | 04-06-2009 |
| JP 2000090734 | A | 31-03-2000 | NONE | | |
| US 5320684 | A | 14-06-1994 | AU 661405 B2 | | 20-07-1995 |
| | | | AU 4370893 A | | 30-12-1993 |
| | | | CA 2113446 A1 | | 09-12-1993 |
| | | | EP 0598887 A1 | | 01-06-1994 |
| | | | JP 7501184 T | | 02-02-1995 |
| | | | JP 3255921 B2 | | 12-02-2002 |
| | | | WO 9324961 A1 | | 09-12-1993 |
| US 2004003836 | A1 | 08-01-2004 | DE 10326274 A1 | | 13-01-2005 |
| | | | JP 3910072 B2 | | 25-04-2007 |
| | | | JP 2003223813 A | | 08-08-2003 |

EPO FORM P0459

For more details about this annex : see Official Journal of the European Patent Office, No. 12/82